Europäisches Patentamt

European Patent Office

Office européen des brevets

(19)

(11) Publication number: **0 111 085**
**B1**

(12) **EUROPEAN PATENT SPECIFICATION**

(45) Date of publication of patent specification: **21.01.87**

(51) Int. Cl.⁴: **H 01 L 21/265**, H 01 L 21/324

(21) Application number: **83109941.1**

(22) Date of filing: **05.10.83**

(54) **Ion implantation process for compound semiconductor.**

(30) Priority: **10.11.82 US 440655**

(43) Date of publication of application:
**20.06.84 Bulletin 84/25**

(45) Publication of the grant of the patent:
**21.01.87 Bulletin 87/04**

(84) Designated Contracting States:
**DE FR GB**

(56) References cited:
**EP-A-0 038 915**

**PATENTS ABSTRACTS OF JAPAN, vol. 5, no.
109 (E-65) (781), July 15, 1981**

(73) Proprietor: **International Business Machines
Corporation
Old Orchard Road
Armonk, N.Y. 10504 (US)**

(72) Inventor: **Hodgson, Rodney Trevor
822 Pinesbridge Road
Ossining New York 10562 (US)**
Inventor: **Jackson, Thomas Nelson
2 Feeney Road
Ossining New York 10562 (US)**
Inventor: **Rupprecht, Hans Stephan
3505 Kamhi Drive
Yorktown Heights New York 10598 (US)**
Inventor: **Woodall, Jerry MacPherson
336 Cherry Street
Bedford Hills New York 10507 (US)**

(74) Representative: **Hobbs, Francis John
IBM United Kingdom Limited Intellectual
Property Department Hursley Park
Winchester Hampshire SO21 2JN (GB)**

Courier Press, Leamington Spa, England.

## Description

This invention relates to processes for ion implanting impuritiesin a compound semiconductor crystal.

Compound semiconductor materials have electro-optical and carrier transport properties useful in semiconductor devices, however, the multiple element crystal responds to the effects of such processing operations as heating in ways that not only affect the location of impurities but also the stoichiometry of the crystal. Where the crystal surface undergoing processing has a relatively large area, such as is the case where an integrated circuit is being produced, the conditions must be uniform over the entire surface area in order to ensure a yield of uniform devices.

One technique of introducing semiconductor property imparting impurities into such crystals is known as ion implantation. This technique has the advantages of precision positioning, and processing in the vicinity of room temperature; but the conventional ion implantation technique also requires a subsequent annealing step at high temperatures which is necessary to repair crystal damage and to activate the implanted impurities.

With large scale integration of circuits, the surface area becomes larger and ion implantation activation annealing results in non-uniformity, the major reason being localised loss of the constituent elements of the compound semiconductor material.

There have been some efforts in the art to overcome the problem of loss of uniformity over a compound semiconductor surface when an ion implantation annealing step is employed. The tendency of the compound semiconductor GaAs to decompose in processing has received some attention in the art. There have been two general techniques employed. The first is by applying a capping layer, such as $SiO_2$, which prevents decomposition. This first technique is disclosed in US—A—4,226,667. The second technique involves the use of a native oxide of the GaAs and this technique is described in US—A—3,969,164. The art has principally been directed to a control of surface stoichiometry. US—A—4,135,952 discloses a process in which an effort is made to keep GaAs from decomposing during ion implantation annealing by placing the GaAs crystal surface in proximity with a GaAs crystal in a Ga solution. The desirability of having an excess of the more volatile element of the GaAs is mentioned in US—A—4,312,681 wherein InAs is used as a source of excess arsenic to prevent decomposition. Each of these techniques requires a standard long, about 30 minutes, annealing step.

For long time annealing steps of the order of 30 minutes using non-proximate conditions to suppress decomposition, out diffusion of certain impurities from the substrate limits the uniformity of electrical activation of the implanted dopant. For proximate contact conditions in suppressing decomposition non-uniformity of implant activation due to the diffusion of the most volatile element to and from the edge and centre of the future circuit area limits the useful size of that area.

In Appl. Phys. Lett. *38*, 8 15 Apr. 1981, p. 639, detrimental effects of diffusion of certain substrate impurities in the material GaAs during long annealing steps is recognized and high excess As pressure from InAs is employed for control.

In Device Research Conference IVA-7-June 26—28, 1982, selective evaporation of GaAs during a conventional long ion implantation annealing step and diffusion of Mn from substrate are reported as problems.

A process comprising implanting ions in a region of a compound semiconductor crystal wafer and subsequently annealing the wafer, is characterised, according to the invention, in that a uniform layer of the most volatile element of the compound semiconductor is provided in solid form in contact with said region and the wafer is annealed at a temperature of 800 to 900°C for a period of 1 to 20 seconds.

The solid source of the most volatile element becomes a uniform controlled gas source during the annealing step used to activate the ion implanted impurities permitting a short, of the order of a few seconds, conventional temperature, annealing step.

The invention prevents decomposition and enhances proper dopant site selection during the annealing and permits a radically shortened annealing cycle.

How the invention can be carried out will now be described by way of example, with reference to the accompanying drawings, in which:—

FIG. 1 is a flow chart of the steps in a process according to the invention; and

FIG. 2 represents a layer of solid arsenic in contact with a GaAs surface during annealing.

In order to facilitate explanation of the invention, the description will be focused on the particular compound semiconductor material gallium arsenide (GaAs) although it will be apparent to one skilled in the art in the light of the principles set forth that those principles can be readily translated to other compound semiconductor materials, such as InP and GaAlAs.

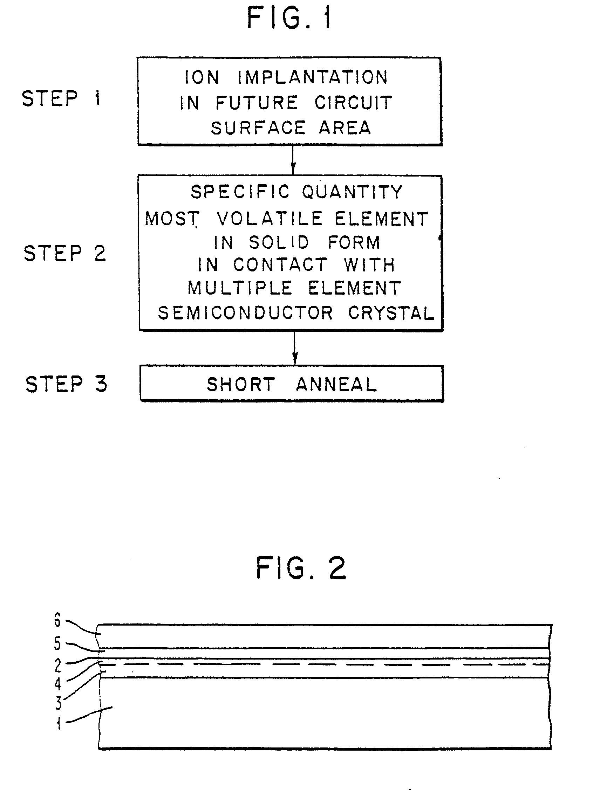

Referring to the flow chart of FIG. 1, in step 1 a compound semiconductor crystal wafer is implanted with semiconductor property imparting ions in the portion of the crystal that is to be the area of a future integrated circuit. The depth and extent of implantation will vary with the properties being imparted. In step 2, the wafer is positioned with the future device area in contact with a uniform solid phase source of the most volatile element of the compound semiconductor. This operates to provide a uniform yet controlled excess quantity of the most volatile element over the entire surface of the substrate which when vaporized in a subsequent annealing step permits a substantially shortened annealing step. An improvement is obtained by disposing the source of the most volatile element in a recess in a backing substrate so that the edges of the backing substrate contact the device area surface and confine the volatile element vapor in a controlled, limited volume.

In step 3, the short time, conventional temperature, annealing step takes place. The extent of the annealing step will be relative to the depth and extent of the implantation but through the benefits of the invention a significantly reduced time is achieved.

Where the material is GaAs, a solid arsenic source in contact with the substrate can be provided as illustrated in FIG. 2. A GaAs wafer 1 has a surface area 2 in which an integrated circuit is to be formed. In practice, the wafer 1 may be equipped with an epitaxial device layer 3 of, for example, GaAs or GaAlAs epitaxially grown thereon. Within the region 4 adjacent to the surface 2 semiconductor property imparting impurities are ion implanted.

It will be understood by one skilled in the art that the structure of FIG. 2 is schematic in that the portion shown is only a two-dimensional section as an example integrated circuit area and that the implanted region 4 may be a layer or a pattern.

In contact with the surface 2, in accordance with the invention, a solid arsenic source is positioned. The arsenic is shown as a layer 5 having a backing 6. The presence of the excess As prevents the formation of oxides of Ga which are difficult to remove. The uniform controlled quantity of As inhibits non-uniform lateral As diffusion. The short temperature annealing cycle reduces out diffusion and/or redistribution of certain substrate impurities.

As a particular example, silicon ions are introduced by ion bombardment into a crystalline GaAs device wafer at energies of 50 to 200 kiloelectron volts (KEV) at fluences of $10^{12}$ to $10^{14}$ ions per square centimeter and depth of 10 nm to 200 nm (100 Å to 2000 Å). The ion bombarded surface is then placed in contact with a layer of arsenic to the order of 1 nm to 50 nm (10 Å to 500 Å) thick formed on a backing substrate of GaAs. Annealing takes place for 1 to 20 seconds at temperatures between 800°C and 900°C.

It will be apparent to one skilled in the art that the future circuit area surface may also be coated with the solid most volatile element prior to the implanting step. This has the beneficial effect of introducing some of the most volatile element into the implanted region adjacent the surface during the implantation step thereby increasing the concentration. A backing (without a layer of the most volatile element) is then placed in contact with the surface during annealing.

The quantity of solid As in contact uniformly all over the surface of the future circuit area when vaporized during the annealing cycle prevents As and Ga erosion, inhibits As concentration changes by diffusion, permits a substantially shorter annealing cycle time, and provides excess As vapor pressure to drive group IV implanted dopants onto donor sites.

## Claims

1. A process comprising implanting ions in a region of a compound semiconductor crystal wafer and subsequently annealing the wafer, characterised in that a uniform layer of the most volatile element of the compound semiconductor is provided in solid form in contact with said region and the wafer is annealed at a temperature of 800 to 900°C for a period of 1 to 20 seconds.

2. A process as claimed in claim 1, in which said uniform layer of the most volatile element comprises a layer of that element formed on the surface of the wafer, the ions being implanted through said layer.

3. A process as claimed in claim 2, in which a backing wafer is provided over the layer of the most volatile element during the annealing operation.

4. A process as claimed in claim 1, in which said uniform layer of the most volatile element comprises a layer of that element formed on a backing substrate.

5. A process as claimed in claim 4, in which the backing substrate is of similar semiconductor material to that of the wafer.

6. A process as claimed in any preceding claim, in which the compound semiconductor consists of GaAs, InP or GaAlAs.

7. A process as claimed in any preceding claim, in which the implanted ions are Si ions implanted to a depth of 10 nm to 200 nm.

8. A process as claimed in any preceding claim, in which said uniform layer of the most volatile element is 1 nm to 50 nm thick.

## Patentansprüche

1. Verfahren, welches das Implantieren von Ionen in einen Bereich einer Verbindungshalbleiterkristall-Wafer und das nachfolgende Glühen der Wafer umfaßt, dadurch gekennzeichnet, daß eine gleichförmige Schicht des am stärksten flüchtigen Elements des Verbindungshalbleiters in fester Form in Berührung mit diesem Bereich vorgesehen und die Wafer bei einer Temperatur von 800 bis 900°C für eine Zeitdauer von 1 bis 20 Sekunden geglüht wird.

2. Verfahren nach Anspruch 1, bei welchem die gleichförmige Schicht des am stärksten flüchtigen Elements eine auf der Oberfläche der Wafer ausgebildete Schicht dieses Elements umfaßt, wobei Ionen durch diese Schicht hindurch implantiert werden.

3. Verfahren nach Anspruch 2, bei welchem eine Unterstützungs-Wafer über der Schicht des am stärksten flüchtigen Elements während des Glühvorgangs vorgesehen wird.

4. Verfahren nach Anspruch 1, bei welchem die gleichförmige Schicht des am stärksten flüchtigen Elements eine auf einem Unterstützungssubstrat ausgebildete Schicht dieses Elements umfaßt.

5. Verfahren nach Anspruch 4, bei welchem das Unterstützungssubstrat aus zu demjenigen der Wafer ähnlichem Halbleitermaterial ist.

6. Verfahren nach irgendeinem vorstehenden Anspruch, bei welchem der Verbindungshalbleiter aus GaAs, InP oder GaAlAs besteht.

7. Verfahren nach irgendeinem vorstehenden Anspruch, bei welchem die implantierten Ionen in eine Tiefe von 10 nm bis 200 nm implantierte Si-Ionen sind.

8. Verfahren nach irgendeinem vorstehenden Anspruch, bei welchem die gleichförmige Schicht des am stärksten flüchtigen Elements 1 nm bis 50 nm dick ist.

**Revendications**

1. Un procédé consistant à implanter des ions dans une région d'une pastille de cristal semi-conducteur composite et ensuite à recuire la pastille, caractérisé en ce qu'une couche uniforme de l'élément le plus volatil du semi-conducteur composite est placée sous une forme solide en contact avec ladite région et la pastille est recuite à une température de 800 à 900°C pendant une période de 1 à 20 secondes.

2. Un procédé tel que revendiqué dans la revendication 1, dans lequel ladite couche uniforme de l'élément le plus volatil comprend une couche de cet élément formée sur la surface de la pastille, les ions étant implantés au travers de ladite couche.

3. Un procédé tel que revendiqué dans la revendication 2, dans lequel une pastille de maintien est placée sur la la couche de l'élément le plus volatil pendant l'opération de recuit.

4. Un procédé tel que revendiqué dans la revendication 1, dans lequel ladite couche uniforme de l'élément le plus volatil comprend une couche de cet élément formée sur un substrat de maintien.

5. Un procédé tel que revendiqué dans la revendication 4, dans lequel le substrat de maintien est formé d'une matière semi-conductrice semblable à celle de la pastille.

6. Un procédé tel que revendiqué dans une quelconque des revendications précédentes, dans lequel le semi-conducteur composite se compose de GaAs, InP ou GaAlAs.

7. Un procédé tel que revendiqué dans une quelconque des revendications précédentes, dans lequel les ions implantés sont des ions de Si implantés à une profondeur de 10 nm à 200 nm.

8. Un procédé tel que revendiqué dans une quelconque des revendications précédentes, dans lequel ladite couche uniforme de l'élément le plus volatil a une épaisseur de 1 nm à 50 nm.

# FIG. 1

STEP 1

| ION IMPLANTATION IN FUTURE CIRCUIT SURFACE AREA |
|---|

STEP 2

| SPECIFIC QUANTITY MOST VOLATILE ELEMENT IN SOLID FORM IN CONTACT WITH MULTIPLE ELEMENT SEMICONDUCTOR CRYSTAL |
|---|

STEP 3

| SHORT ANNEAL |
|---|

# FIG. 2